## Europäisches Patentamt
## European Patent Office
## Office européen des brevets

(19)

(11) Veröffentlichungsnummer: **0 075 647**
**B1**

(12)

# EUROPÄISCHE PATENTSCHRIFT

(45) Veröffentlichungstag der Patentschrift:
**02.05.85**

(51) Int. Cl.⁴: **H 03 J 7/18,** H 03 G 3/34

(21) Anmeldenummer: **82103928.6**

(22) Anmeldetag: **06.05.82**

(54) **Schaltungsanordnung zur Ermittlung der Empfangsqualität für einen FM-Empfänger.**

(30) Priorität: **26.09.81 DE 3138395**

(43) Veröffentlichungstag der Anmeldung:
**06.04.83 Patentblatt 83/14**

(45) Bekanntmachung des Hinweises auf die Patenterteilung:
**02.05.85 Patentblatt 85/18**

(84) Benannte Vertragsstaaten:
**AT FR GB IT**

(56) Entgegenhaltungen:
**EP - A - 0 069 214**
**DE - A - 1 591 144**
**DE - A - 2 345 649**
**DE - A - 2 840 533**
**US - A - 3 448 385**

**ELEKTOR, Band 2, Nr. 7-8, Juli-August 1976, Canterbury (GB)**

(73) Patentinhaber: **Blaupunkt-Werke GmbH,**
**Robert-Bosch-Strasse 200, D-3200 Hildesheim (DE)**

(72) Erfinder: **Seibold, Peter, Dipl.-Ing., Lehmkamp 33 D, D-3201 Diekholzen (DE)**

(74) Vertreter: **Ellers, Norbert, Dipl.-Phys., Blaupunkt-Werke GmbH Robert-Bosch-Strasse 200, D-3200 Hildesheim (DE)**

## Beschreibung

Die Erfindung bezieht sich auf eine Schaltungsanordnung zur Ermittlung der Empfangsqualität an der Antenne eines FM-Empfängers nach der europäischen Patentanmeldung EP-A Nr. 69214 (Veröffentlichungstag: 12.1.1983, nach dem Anmeldetag der vorliegenden Anmeldung), bei der dem FM-Demodulator des Empfängers ein selektives Filter mit einer relativ geringen Bandbreite oberhalb des Stereo-Multiplex-Signals, innerhalb der ZF-Bandbreite nachgeschaltet ist, der Filterausgang auf eine Integrationsstufe geführt, deren Ausgang mit dem Eingang einer Pegelvergleichsstufe verbunden ist und das Ausgangssignal der Pegelvergleichsstufe als bewertetes Störsignal eine Steuerschaltung schaltet, die eine Sendersuchlaufschaltung oder eine Antennen-Diversity-Schaltung umfasst.

Bei Sendersuchlaufanordnungen oder Antennen-Diversity-Empfang ist es erforderlich, den jeweils eingestellten Sender/Antenne auf Empfangsqualität zu prüfen. Als Messgrösse für die Empfangsqualität wird bei den bekannten Schaltungsanordnungen der HF-Eingangspegel des Empfängers herangezogen. Dabei ist es völlig belanglos, ob es sich um einen üblichen Sendersuchlauf oder um einen Sendersuchlauf mit abgespeicherten Senderfrequenzen handelt, bei dem der HF-Eingangspegel des empfangenen Senders mit zuvor gespeicherten HF-Pegelwerten anderer Senderstationen verglichen wird.

Aus der US-A Nr. 3448385 ist eine Squelch-Schaltung für einen FM-Empfänger bekannt, die eine Schaltungsanordnung zur Ermittlung der Empfangsqualität enthält, bei der dem FM-Demodulator des Empfängers ein Hochpass mit einer Grenzfrequenz von 75 kHz nachgeschaltet ist, dessen Ausgang mit dem Eingang einer Pegelvergleichsstufe verbunden ist. Beim Überschreiten eines vorgegebenen Pegels durch oberhalb der Grenzfrequenz auftretende Störsignale erzeugt die Pegelvergleichsstufe ein zur Stummschaltung des Empfängers dienendes Ausgangssignal.

Aus der DE-PS Nr. 1591144 ist eine Empfangseinrichtung mit zwei Empfängerzügen und einer automatischen Umschalteinrichtung bekannt, durch die immer derjenige der auf Sender gleichen Modulationsinhaltes abgestimmten Empfängerzüge durchgeschaltet wird, der die bessere Empfangsqualität bietet. Dabei wird eine Umschalteinrichtung über eine die Hochfrequenzeingangspegel vergleichende Pegelvergleichseinrichtung sowie über eine Modulationsvergleichseinrichtung derart gesteuert, dass abwechselnd immer der die bessere Empfangsqualität bietende Empfängerzug abgestimmt und sein Niederfrequenzausgang durchgeschaltet ist, während der andere Empfängerzug Suchläufe durchführen kann.

Bei diesen bekannten Schaltungsanordnungen wird davon ausgegangen, dass die Empfangsqualität der Feldstärke und damit dem HF-Pegel proportional ist. Dieses trifft aber nur dann zu, wenn ideale Empfangsverhältnisse vorliegen. Beispielsweise macht sich beim Autoradio der Mehrwegeempfang oder der während der Fahrt auftretende, durch Reflexionen hervorgerufene, sogenannte Lattenzauneffekt sehr störend bemerkbar. Die Qualität eines solchen Empfangssignals ist nicht mehr an dem HF-Eingangspegel messbar, insbesondere, wenn dieser so hoch liegt, dass der Begrenzer im UKW-Teil wirksam ist. Es ist durchaus möglich, dass ein Signal mit hohem HF-Eingangspegel völlig empfangsunwürdig ist, während ein Signal mit geringem HF-Eingangspegel durchaus empfangswürdig sein kann. Insbesondere bei Autoradios ist daher eine befriedigende Beurteilung der Qualität eines empfangenen Signals aufgrund des HF-Eingangspegels kaum möglich. Bei den bekannten Schaltungsanordnungen kann die Schwierigkeit auftreten, dass das Mass für die Empfangsqualität im unteren Bereich der Feldstärke zu einer scheinbar guten Qualität verzerrt wird, da in diesem Bereich das Nutzsignal schneller als das Störsignal abnimmt.

Die erfindungsgemässe Schaltungsanordnung zur Ermittlung der Empfangsqualität mit den kennzeichnenden Merkmalen des Hauptanspruchs hat demgegenüber den Vorteil, dass mit ihr im unteren Feldstärkenbereich auftretende Verzerrungen des Masses für die Empfangsqualität verringert werden können. Ein besonders einfacher Aufbau eines elekronisch gesteuerten Pegeleinstellers ist mit einer Anordnung nach Anspruch 2 möglich.

Ausführungsbeispiele der Erfindung sind in der Zeichnung dargestellt und in der nachfolgenden Beschreibung näher erläutert. Es zeigen:

Fig. 1 ein Blockschaltbild, und

Fig. 2 ein weiteres Schaltbild einer Schaltungsanordnung zur Ermittlung der Empfangsqualität.

Fig. 3 zeigt ein Ausführungsbeispiel eines elektronisch steuerbaren Pegeleinstellers, und

Fig. 4 zeigt das Mass der Empfangsqualität in Abhängigkeit von der Feldstärke gemäss der erfindungsgemässen Schaltungsanordnung.

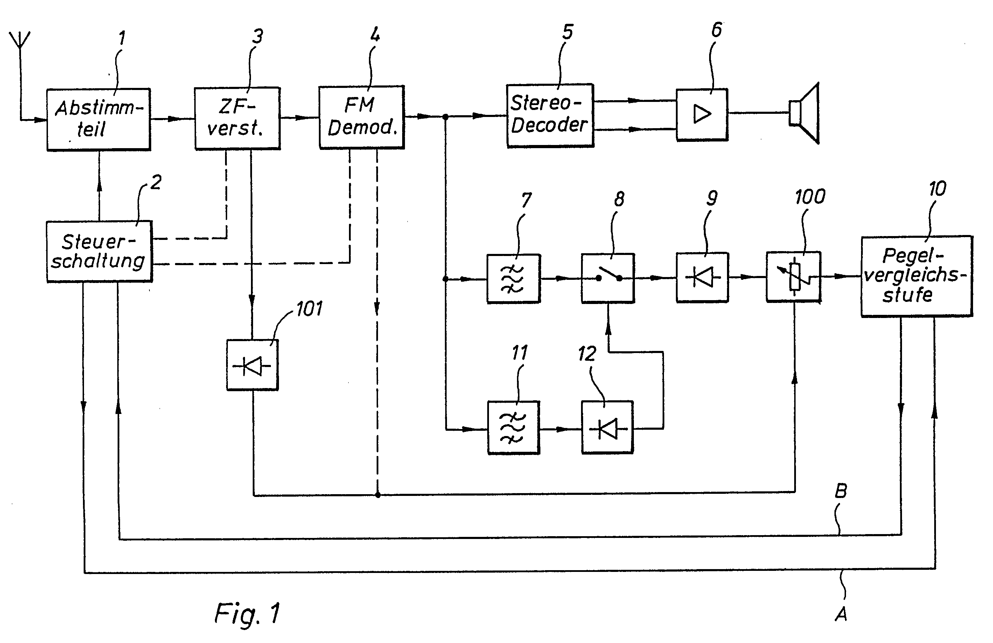

Ein in der Fig. 1 als Blockschaltbild dargestellter, für Stereoempfang eingerichteter UKW-Suchlaufempfänger weist ein UKW-Abstimmteil 1, eine Steuerschaltung 2 für einen Sendersuchlauf, einen ZF-Verstärker 3, einen FM-Demodulator 4, einen Stereodecoder 5 sowie einen NF-Verstärker 6 in an sich bekannter Weise auf. Der Ausgang des FM-Demodulators 4 ist über ein selektives Filter 7, dessen Durchlassfrequenz oberhalb des Stereo-Multiplex-Signals und innerhalb der ZF-Bandbreite liegt, und über einen elektrischen Torschalter 8 mit einer ersten Gleichrichterstufe 9 verbunden, der über einen elektronisch steuerbaren Pegeleinsteller 100 eine Pegelvergleichsstufe 10 nachgeschaltet ist. Der Steuereingang des Pegeleinstellers 100 ist über eine Gleichrichterstufe 101 mit dem ZF-Verstärker 3 verbunden. Der Ausgang des FM-Demodulators 4 ist ausserdem über einen NF-Bandpass 11 mit einer als Spitzengleichrichter ausgebildeten zweiten Gleichrichterstufe 12 verbunden, welche mit ihrem Ausgangssignal den elektrischen Torschalter 8 betätigt. Der Ausgang und ein weiterer Eingang der Pegelvergleichsstufe 10 sind über Leitungen A und B mit der Steuerschaltung 2 für den Sendersuchlauf verbunden.

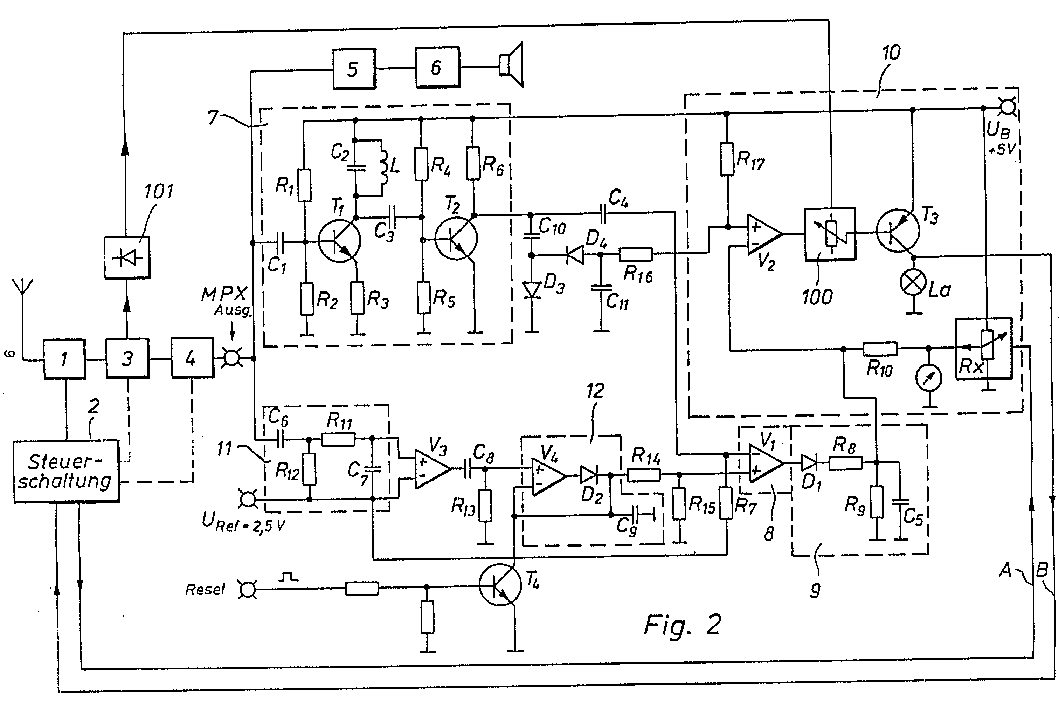

Weitere Einzelheiten eines erfindungsgemässen Ausführungsbeispiels nach Fig. 1 sind aus der Fig. 2 ersichtlich. Die Bezugszeichen der Fig. 1 wurden beibehalten. Als selektives Filter ist ein aus Widerständen R1 bis R6, Kondensatoren C1 bis C3, Transistoren T1, T2, und einer Induktivität L aufgebauter selektiver Verstärker vorgesehen, dessen Schwingkreis C2/L bei einer Güte von etwa Q = 10 auf eine Frequenz von ca. 150 kHz abgestimmt ist. Der Ausgang des als selektives Filter 7 dienenden Verstärkers ist über einen Kondensator C4 mit dem über einen Widerstand R7 an einer positiven Referenzspannungsquelle $U_{ref}$ liegenden invertierenden Eingang eines ersten Operationsverstärkers V1 verbunden. Der Ausgang des zusätzlich als Torschaltung 8 dienenden Operationsverstärkers V1 ist mit der Anode einer Diode D1 verbunden, deren Katode über einen Widerstand R8 mit einem an Masse liegenden Ladekondensator C5, dem ein Widerstand R9 parallel geschaltet ist, verbunden. Der mit den Widerständen R8, R9 verbundene Anschluss des ein Integrationsglied bildenden Kondensators C5 ist mit dem invertierenden Eingang eines zweiten Operationsverstärkers V2 verbunden, welcher zusammen mit einem nachgeschalteten Transistor T3, einer Anzeigelampe La und einem einstellbaren Spannungsteiler Rx, dessen Abgriff über einen Widerstand R10 mit dem nichtinvertierenden Eingang des Operationsverstärkers V2 verbunden ist, die Pegelvergleichsstufe 10 bildet.

Den NF-Bandpass 11 bildende Kondensatoren C6, C7 und Widerstände R11, R12 sind derart bemessen, dass der NF-Bandpass 11 einen Durchlassbereich von ca. 200 bis 5000 Hz aufweist. Die Ausgangsklemmen des NF-Bandpasses sind mit den Eingängen eines dritten Operationsverstärkers V3 verbunden, wobei der invertierende Eingang mit der Referenzspannungsquelle $U_{ref}$ verbunden ist. Der Ausgang des dritten Operationsverstärkers V3 ist über einen Kondensator C8 mit dem über einen Widerstand R13 an Masse liegenden nichtinvertierenden Eingang eines vierten Operationsverstärkers V4 verbunden, dessen invertierender Eingang mit dem Kollektor eines mit dem Emitter an Masse liegenden Transistors T4 verbunden ist. Der Ausgang des vierten Operationsverstärkers V4 ist mit der Anode einer mit ihrer Katode ebenfalls am invertierenden Eingang liegenden Diode D2 verbunden. Die über einen Kondensator C9 an Masse liegende Katode der Diode D2 ist über einen Widerstand R14 mit dem über einen Widerstand R15 an Masse liegenden nichtinvertierenden Eingang des als Torschalter 8 vorgesehenen ersten Operationsverstärkers V1 verbunden.

An den Ausgang des als Verstärker ausgebildeten selektiven Filters 7 ist eine als Spannungsverdopplerschaltung ausgelegte Gleichrichteranordnung, welche aus Dioden D3, D4, Kondensatoren C10, C11 und einem Widerstand R16 besteht, angeschlossen. Die Dioden D3, D4 der Gleichrichteranordnung sind derart gepolt, dass eine an ihrem Ausgang entstehende Spannung negativ gerichtet ist.

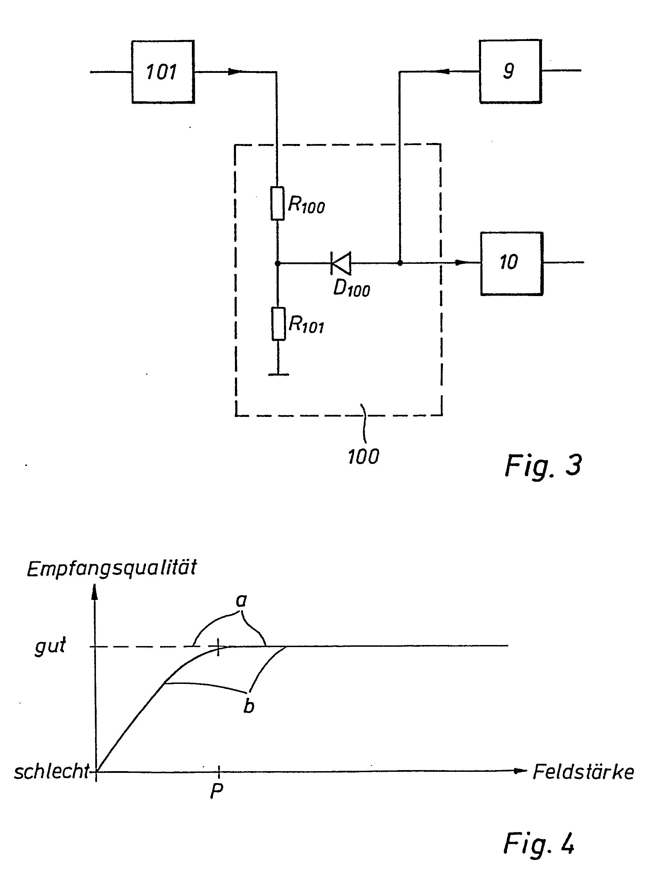

Der Ausgang der Gleichrichteranordnung ist über den Widerstand R16 mit dem über einen Widerstand R17 mit einer positiven Betriebsspannungsquelle +UB verbundenen nichtinvertierenden Eingang des zweiten Operationsverstärkers V2 verbunden, dessen Ausgang über einen elektronisch steuerbaren Pegeleinsteller 100 mit der Basis des Transistors T3 verbunden ist. Der Steuereingang des Pegeleinstellers 100 ist über eine Gleichrichterstufe 101 mit dem ZF-Verstärker 3 verbunden. Ein besonders einfaches Ausführungsbeispiel des steuerbaren Pegeleinstellers 100 ist in der Fig. 3 dargestellt. Der Pegeleinsteller 100 weist im wesentlichen einen ohmschen Spannungsteiler R100/R101 und eine Diode D100 auf.

Wird mit dem vorgenannten Empfänger ein in Folge von Mehrwegeempfang, Abschattung, Seitenbandstörungen durch Nachbarsender, Zündstörung usw. gestörtes Signal empfangen, so treten am Ausgang des FM-Demodulators 4 auch oberhalb des Multiplexsignalbereiches, also oberhalb von 53 kHz, Störimpulse auf. Mit dem einen Verstärker aufweisenden selektiven Filter 7 werden vorzugsweise die Störanteile im Bereich von 150 kHz erkannt und verstärkt. Die Störanteile gelangen nun über den Kondensator C4, den ersten Operationsverstärker V1 zur ersten Gleichrichterstufe 9, welche den Ladekondensator C5 auflädt. Die Höhe der Spannung an diesem Kondensator C5 ist bereits ein Mass für die Grösse der Störanteile sowie für die Empfangsqualität des empfangenen Signals.

Durch Mehrwegeempfang verursachte Störungen treten nur dann störend auf, wenn eine NF-Modulation des Trägers vorhanden ist. Es ist daher zweckmässig, bei Modulationspausen keine Messungen vorzunehmen. Hierzu wird ein NF-Frequenzanteil des am Ausgang des FM-Demodulators anstehenden Signals über den NF-Bandpass 11 und den dritten Operationsverstärker V3 der als Spitzengleichrichter ausgebildeten zweiten Gleichrichterstufe 12 geführt. Das am Kondensator C9 anstehende Gleichspannungssignal gibt Aufschluss darüber, ob ein NF-Modulationssignal vorliegt oder nicht. Die Rückstellzeitkonstante für einen Ausfall der NF-Modulation wird durch die Dimensionierung der Widerstände R14, R15 und des Kondensators C9 bestimmt. Über den Steuereingang des Transistors T4 kann zu Beginn jeder Messung durch einen Reset-Impuls auf aktuelle NF-Wiedergabe abgefragt werden.

Bei vorhandenem Modulationssignal gelangt von der Diode D2 eine positive Spannung an den nichtinvertierenden Eingang des Operationsverstärkers V1, wodurch dieser die ihm über den Kondensator C4 zugeführten Störsignale verstärkt. Die verstärkten und mittels der Diode D1 gleichgerichteten Störsignale werden dem Ladekondensator C5 zugeführt und nach Frequenz, Häufigkeit und Amplitude integriert. Durch den resultierenden Widerstandswert der parallel wirkenden Widerstände R9, R10 wird die für die Messzeit ausschlaggebende Integrationsdauer bestimmt. Je häufiger bzw. anhaltender Störsignale auftreten, desto höher ist die Gleichspannung am Kondensator C5.

Die Ladespannung von C5 sowie die am einstellbaren Spannungsteiler Rx abgegriffene Gleichspannung werden dem invertierenden Eingang des zweiten Operationsverstärkers V2 zugeführt. Bei einem hohen Störgrad des empfangenen Signals ist der Ladekondensator C5 maximal aufgeladen, über den Spannungsteiler Rx ist eine kleine Gleichspannung zum Störvergleich einzuregeln, um ein Umkippen des Ausgangsstatus vom Operationsverstärker V2 und somit ein Durchschalten des Transistors T3 und ein Aufleuchten der Anzeigelampe La zu erreichen. Bei fehlenden Störungen ist der Ladekondensator C5 ungeladen. Um wiederum eine Anzeige zu erhalten, muss der Spannungsteiler Rx auf eine maximale Gleichspannung geregelt werden. Hierdurch ist es nun möglich, den Grad der Störungen durch eine Auswertung der mit dem Spannungsteiler Rx eingestellten Vergleichsspannung zu bewerten.

Treten nun länger anhaltende, insbesondere durch Nachbarsender, mangelnde Selektion, Zündfunken usw., hervorgerufene Störungen auf, so wird durch eine Trägergleichrichtung mittels der Dioden D3, D4 eine negative Gleichspannung erzeugt, welche im Fusspunkt des aus den Widerständen R16, R17 gebildeten Spannungsteilers eingespeist wird. Hierdurch verschiebt sich der Arbeitspunkt des zweiten Operationsverstärkers V2 und somit wird eine Addition der unterschiedlichen Störgrössen möglich, welche ebenfalls über die Grösse der am Spannungsteiler Rx eingestellten Spannung bewertbar ist.

Für die richtige Bewertung der Qualität eines Empfangssignals werden der Pegelvergleichsstufe 10 über die Leitung A von der Steuerschaltung für Sendersuchlauf 2 unterschiedliche Pegelwerte vorgegeben. Das Unter- bzw. Überschreiten eines vorgegebenen Pegels durch einen Pegel des Istwertes wird der Steuerschaltung 2 über die Leitung B mitgeteilt. Somit ist es möglich, nicht nur die Störpegel zweier mit getrennten Empfängerzügen gleichzeitig empfangener Sender miteinander zu vergleichen, sondern auch die Störpegelwerte zuvor empfangener Sender zu speichern und diese als Sollwerte für einen Pegelvergleich beim Empfang eines Senders zu verwenden. Es ist jedoch auch ohne weiteres möglich, lediglich die an den Kondensatoren C5 und/oder C11 auftretenden Spannungen für die Beurteilung einer Störung zu verwenden.

Bei einer Schaltungsanordnung nach der europäischen Patentanmeldung EP-A Nr. 69214 würde die der Pegelvergleichsstufe 10 entnehmbare Messgrösse der Empfangsqualität als Funktion der Feldstärke etwa gemäss der Kurve a der Fig. 4 verlaufen. Da jedoch im unteren Feldstärkenbereich die Begrenzung des ZF-Verstärkers 3 verlassen wird und das Nutzsignal schneller als das Störsignal abnimmt, wird in diesem Bereich das Qualitätsmass zu einer scheinbar guten Qualität verzerrt. Mit einer erfindungsgemässen Schaltungsanordnung wird dagegen die Messgrösse der Empfangsqualität derart beeinflusst, dass sich unterhalb eines vorgegebenen niedrigen HF-Eingangspegels P die Messgrösse gemäss der Fig. 4, Kurve b, bei abnehmender Feldstärke verringert.

Die zur Steuerung des elektronisch einstellbaren Pegeleinstellers 100 erforderliche Messgrösse für die Feldstärke ist der ZF-Stufe 3 in an sich bekannter Weise über eine Gleichrichterstufe 101 entnehmbar. Zur Gewinnung der Messgrösse für die Feldstärke kann zusätzlich auch der FM-Demodulator 4 herangezogen werden.

## Patentansprüche

1. Schaltungsanordnung zur Ermittlung der Empfangsqualität an der Antenne eines FM-Empfängers, bei der dem FM-Demodulator (4) des Empfängers ein selektives Filter (7) mit einer relativ geringen Bandbreite oberhalb des Stereo-Multiplex-Signals, innerhalb der ZF-Bandbreite nachgeschaltet ist, dessen Ausgang mit dem Eingang einer Pegelvergleichsstufe (10) verbunden ist und das Ausgangssignal der Pegelvergleichsstufe (10) als bewertetes Störsignal eine Steuerschaltung (2) schaltet, dadurch gekennzeichnet, dass der Ausgang des selektiven Filters (7) über eine Integrationsstufe mit dem Eingang der Pegelvergleichsstufe (10) verbunden ist, dass die Steuerschaltung (2) eine Sendersuchlaufschaltung oder eine Antennen-Diversity-Schaltung umfasst und dass im Signalweg des bewerteten Störsignals ein in Abhängigkeit vom HF-Eingangspegel elektronisch steuerbarer Pegeleinsteller (100) vorgesehen ist, dessen Steuerkurve derart ausgelegt ist, dass sich der Wert der Pegelvergleichsstufe (10) entnehmbaren Messgrösse der Empfangsqualität unterhalb eines vorgegebenen niedrigen HF-Eingangspegels (P) bei abnehmender Feldstärke verringert.

2. Schaltungsanordnung zur Ermittlung der Empfangsqualität nach Anspruch 1, dadurch gekennzeichnet, dass als elektronisch steuerbarer Pegeleinsteller (100) eine einen ohmschen Spannungsteiler (R100/R101) und eine Diode (D100) aufweisende Subtrahierstufe vorgesehen ist.

## Claims

1. Circuit arrangement for determining the figure of merit of reception at the antenna of an FM receiver, in which arrangement the FM demodulator (4) of the receiver is followed by a selective filter (7) having a relatively narrow bandwidth above the stereo multiplex signal within the IF bandwidth, the output of which filter is connected to the input of a level comparison stage (10), and the output signal of the level comparison stage (10), as a weighted noise signal, switches a control circuit (2), characterised in that the output of the selective filter (7) is connected *via* an integrating stage to the input of the level comparison stage (10), in that the control circuit (2) comprises a station-finding circuit or an antenna diversity circuit, and in that in the signal path of the weighted noise signal a gain control (100) is provided which is electronically controllable in dependence on the RF input level and the control characteristic of which is designed in such a manner that the value of the measured quantity of the figure of merit of reception, which value can be obtained from the level comparison stage (10), decreases with decreasing field strength below a predetermined low RF input level (P).

2. Circuit arrangement for determining the figure of merit of reception according to Claim 1, characterised in that a subtracting stage provided with a resistive voltage divider (R100/R101) and a diode (D100) is provided as electronically controllable gain control (100).

**Revendications**

1. Montage pour déterminer la qualité de réception sur l'antenne d'un récepteur MF dans lequel le modulateur MF (4) du récepteur est suivi par un filtre sélectif (7) avec une largeur de bande relativement faible au-delà du signal multiplex stéréo, dans la largeur de bande FI, dont la sortie est reliée à l'entrée d'un étage de comparaison de niveau (10), commutant un circuit de commande (2) comme signal parasite exploité, caractérisé en ce que la sortie du filtre sélectif (7) est reliée à l'entrée de l'étage de comparaison de niveau (10) par un étage intégrateur, en ce que le circuit de commande (2) comprend un circuit de recherche de stations ou un circuit de diversité d'antennes, et en ce que, dans le chemin du signal parasite exploité, il est prévu un dispositif de réglage de niveau (100) à commande électronique en fonction du niveau d'entrée (HF) et dont la courbe de commande est réalisée de façon que la valeur des grandeurs de mesure de la qualité de réception prise sur l'étage de comparaison de niveau (100) diminue en dessous d'un niveau d'entrée (HF) (P) bas, prédéterminé lorsque l'intensité du champ diminue.

2. Montage pour déterminer la qualité de réception selon la revendication 1, caractérisé en ce que le dispositif de réglage de niveau (100) à commande électronique est constitué par un étage soustracteur comprenant un diviseur de tension ohmique (R100/R101) et une diode (D100).

Fig. 1

0 075 647

Fig. 2

Fig. 3

Fig. 4